Europäisches Patentamt

European Patent Office

Office européen des brevets

(19)

(11) EP 0 657 997 B1

(12) **FASCICULE DE BREVET EUROPEEN**

(45) Date de publication et mention
de la délivrance du brevet:
**18.11.1998 Bulletin 1998/47**

(51) Int Cl.$^6$: **H03G 3/20**

(21) Numéro de dépôt: **94402767.1**

(22) Date de dépôt: **02.12.1994**

(54) **Procédé de commande automatique de gain dans un récepteur radio numérique et récepteur mettant en oeuvre ce procédé**

Verfahren und Vorrichtung zur automatischen Verstärkungsregelung in einem digitalen Empfänger und damit ausgerüsteter Empfänger

Method for the automatic gain control in a digital receiver and receiver using this method

(84) Etats contractants désignés:
**DE GB**

(30) Priorité: **07.12.1993 FR 9314647**

(43) Date de publication de la demande:
**14.06.1995 Bulletin 1995/24**

(73) Titulaire: **THOMSON-CSF**
**75008 Paris (FR)**

(72) Inventeurs:
• **Demeure, Cédric**
**F-92402 Courbevoie Cédex (FR)**
• **Berranger, Robert**
**F-92402 Courbevoie Cédex (FR)**

• **Coutolleau, Marc**
**F-92402 Courbevoie Cédex (FR)**

(74) Mandataire: **Lincot, Georges et al**
**Thomson-CSF Propriété Intellectuelle,**
**13, Avenue du Président Salvador Allende**
**94117 Arcueil Cédex (FR)**

(56) Documents cités:
**EP-A- 0 413 311          GB-A- 2 229 333**

• **PATENT ABSTRACTS OF JAPAN vol. 10 no. 150
(E-408) [2207] ,31 Mai 1986 & JP-A-61 009009
(OKI DENKI)**

## Description

La présente invention concerne un procédé de commande automatique de gain dans un récepteur numérique et un récepteur mettant en oeuvre ce procédé.

Elle s'applique notamment à la réalisation de récepteurs radio numériques (voir, par example, EP-A-0 413 311) permettant l'acheminement d'un signal porteur d'informations depuis sa sortie d'une antenne vers un dispositif d'écoute formé par un haut-parleur ou vers un modem (modulateur-démodulateur) pour la transmission en numérique après codage par un convertisseur analogique-numérique des informations reçues, et transposition éventuelle de l'onde porteuse sur deux ou plusieurs fréquences intermédiaires. Comme le niveau du signal reçu à l'entrée d'un récepteur dépend de la puissance émise par l'émetteur, des conditions de propagation, des antennes utilisées et des autres moyens de communication de fréquences porteuses proches, les récepteurs sont généralement munis de dispositifs de commande automatique de gain pour l'ajustement de la puissance de sortie en fonction du niveau du signal reçu. Cependant comme les conditions de propagation et d'environnement imposent une adaptation rapide et efficace du gain du récepteur, les dispositifs de commande de gain automatique ont été traditionnellement mis en oeuvre en analogique en sortie d'un filtre de canal étroit, à quartz par exemple. Dans un récepteur utilisant le traitement numérique pour réaliser le filtrage de canal, le convertisseur analogique-numérique qui est placé en sortie d'un étage de fréquence intermédiaire reçoit dans ces conditions les canaux adjacents non atténués par l'étage de fréquence intermédiaire dont la bande passante est plus large que celle du filtre canal, ce qui entraîne une pollution du signal utile par des brouilleurs situés à proximité.

Le but de l'invention est de pallier l'inconvénient précité.

A cet effet, l'invention a pour objet un procédé de commande automatique du gain d'un récepteur radio numérique comportant une chaîne d'amplification à fréquence intermédiaire couplée à un convertisseur analogique-numérique consistant à mesurer l'énergie haute fréquence du signal appliqué par la chaîne d'amplification à fréquence intermédiaire sur le convertisseur analogique-numérique, à mesurer après filtrage canal l'énergie basse fréquence du signal de sortie du récepteur caractérisé en ce qu'il consiste à commander le gain de la chaîne d'amplification à fréquence intermédiaire à partir des énergies haute fréquence et basse fréquence du signal en comparant l'énergie haute fréquence courante à une valeur de seuil d'énergie Ref déterminée en fonction de l'énergie haute fréquence du signal appliqué sur le convertisseur analogique-numérique.

L'invention a également pour objet un récepteur pour la mise en oeuvre du procédé précité.

D'autres caractéristiques et avantages de l'invention apparaîtront à l'aide de la description qui suit faite en regard des dessins annexés qui représentent:

- La figure 1 un schéma synoptique global d'un récepteur numérique selon l'invention ;
- La figure 2 un organigramme figurant les étapes du procédé de commande de la boucle de commande automatique de gain haute fréquence selon l'invention ;
- Les figures 3 et 4 des dispositifs de mesure d'énergie haute fréquence et basse fréquence mis en oeuvre dans le récepteur selon l'invention ;
- La figure 5 un organigramme représentant le procédé de commande de la boucle de commande automatique de gain basse fréquence selon l'invention.

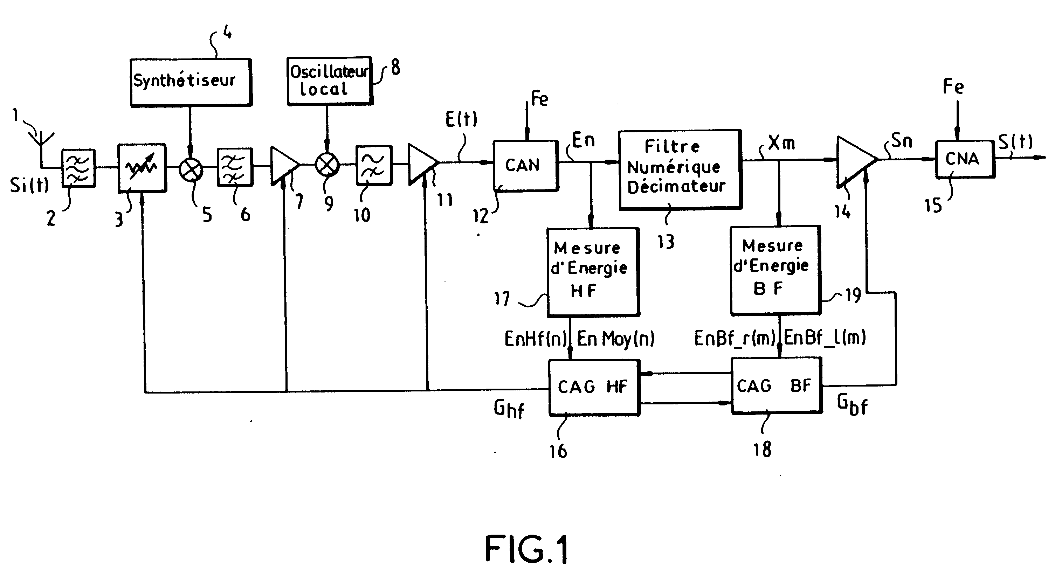

Dans le mode de réalisation du récepteur numérique selon l'invention qui est représenté à la figure 1, le signal radio $Si(t)$ reçu par le récepteur est capté par une antenne 1 couplée à un filtre de gammes de fréquence 2. Le signal obtenu à la sortie du filtre de gamme 2 est atténué par un atténuateur variable 3 avant d'être transposé sur une première fréquence intermédiaire à l'aide d'un synthétiseur de fréquence 4 et d'un mélangeur de fréquences 5. Le signal obtenu à la sortie du mélangeur de fréquences 5 est filtré par un filtre à bande étroite 6 et amplifié par un amplificateur à gain variable 7. Le signal obtenu à la sortie de l'amplificateur 7 est transposé sur une deuxième fréquence intermédiaire par un oscillateur local 8 alimentant un mélangeur de fréquences 9. La sortie du mélangeur de fréquences 9 est couplée à l'entrée d'un filtre 10 qui élimine les produits de mélange indésirables et un amplificateur à gain variable élevé 11 applique le signal amplifié à l'entrée d'un convertisseur analogique-numérique 12. Le signal converti obtenu à la sortie du convertisseur analogique-numérique 12 est appliqué à l'entrée d'un filtre canal 13 formé par un filtre numérique décimateur qui ne garde que la partie d'intérêt du spectre du signal reçu. Le signal $Xm$ obtenu à la sortie du filtre canal 13 est ensuite amplifié par un amplificateur à gain variable 14 avant d'être appliqué à un convertisseur numérique-analogique 15 pour la sortie finale du signal désiré. Ce dernier composant 15 n'est pas nécessaire si des traitements numériques supplémentaires sont utilisés (ex. : Modem).

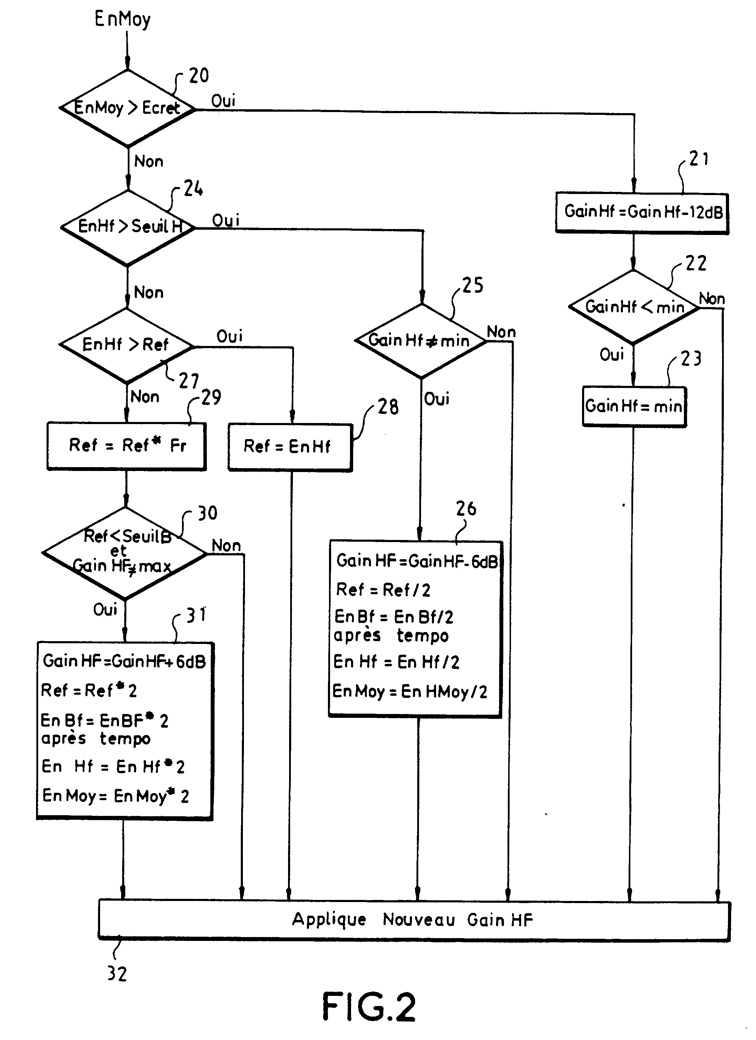

Comme le niveau du signal acquis par le convertisseur analogique-numérique 12 est limité par la dynamique de celui-ci, un trop fort niveau entraînant un écrêtage du signal et donc une importante distorsion, et un niveau trop faible entraînant une dégradation du rapport signal à bruit de quantification, un dispositif de commande automatique de gain 16 est couplé à la sortie du convertisseur analogique-numérique 12 par l'intermédiaire d'un dispositif de mesure de l'énergie haute fréquence 17 du signal obtenu à la sortie du convertisseur 12 afin d'agir sur le rapport d'atténuation de l'atténuateur 3 et sur les gains des amplificateurs 7 et 11. Un dispositif de commande automatique de gain 18 est également couplé entre le dispositif de commande automatique de gain 16 et à la sortie du filtre canal 13 par l'intermédiaire d'un dispositif de mesure de l'énergie basse fréquence 19 sortant du filtre 13 pour agir de façon classique sur le niveau du signal basse fréquence obtenu à la sortie du filtre numérique 13. Le rôle des dispositifs 16 et 18 est de régler d'une part, le niveau bande large du signal de fréquence intermédiaire et d'autre part, de réguler de façon classique le niveau du signal basse fréquence obtenu à la sortie du filtre canal 13. Comme le dispositif 18 est couplé au dispositif 16 cette disposition permet par le filtre canal 13 d'éliminer un brouilleur qui est en dehors de la bande utile sans modifier le niveau du signal appliqué sur le convertisseur 12, par contre lorsqu'un brouilleur est contenu dans la bande utile du récepteur celui-ci est pris en compte par le dispositif de contrôle automatique de gain 16 et 18. Le dispositif de contrôle automatique de gain 16 opère de la façon représentée par l'organigramme de la figure 2. Le processus de traitement repose sur un calcul d'une référence d'énergie Ref qui est actualisée en fonction de la valeur de l'énergie du signal mesurée en sortie du convertisseur analogique-numérique 12. Si un seuil haut ou bas est atteint, une action est prise pour commander l'atténuateur de tête 3 et les amplificateurs 7 et 11 dans la mesure où les gains maximum ou minimum ne sont pas atteints. Après tout changement de gain, les paramètres sont modifiés de manière à ce que le dispositif 18 réagisse en fonction du temps de propagation à travers le filtre numérique 13. La valeur Fr qui actualise la référence détermine la constante de temps de resensibilisation. Le procédé commence par un test de détection d'écrêtage 20 consistant à comparer l'énergie moyenne courante EnMoy du signal obtenu en sortie du convertisseur analogique-numérique 12 à une première valeur de seuil déterminée Ecret. Si l'énergie moyenne courante EnMoy est supérieure à la valeur de seuil Ecret une modification du gain haute fréquence Gain-Hf est exécutée à l'étape 21 en diminuant d'une valeur constante de 12 dB par exemple le gain de la chaîne haute fréquence. A l'étape 22 un test a lieu pour vérifier que le gain haute fréquence (Gain-Hf) est inférieur à une valeur de gain minimum. Si tel est le cas, le gain est limité à cette valeur minimum à l'étape 23, par contre cette valeur de gain est conservée si elle est supérieure à cette valeur de gain minimum. S'il n'y a pas d'écrêtage détecté à l'étape 20 un test a lieu à l'étape 24 consistant à comparer l'énergie du signal détecté à une deuxième valeur de seuil déterminée Seuil H inférieure à la première. Ce test permet de détecter une augmentation de l'énergie haute fréquence EnHf du signal reçu au-delà du seuil Seuil H. Dans ce cas l'étape 25 suivante consiste à vérifier si le gain haute fréquence était précédemment à sa valeur minimale et si c'est le cas rien n'est modifié, par contre, dans le cas contraire plusieurs traitements sont effectués à l'étape 26 consistant par exemple à diminuer le gain haute fréquence d'une valeur de gain constante de 6 dB, à diviser la valeur de référence Ref par deux, à diviser par deux l'énergie EnBf du signal basse fréquence obtenu à la sortie du filtre canal 13 en tenant compte du délai correspondant au temps de propagation du signal à travers la chaîne de réception, à diviser l'énergie haute fréquence EnHf par deux et à diviser l'énergie moyenne EnMoy par deux. La temporisation nécessaire entre la décision pour modifier l'énergie du signal Bf et l'appliquer doit prendre en compte le temps de propagation du signal à travers la chaîne de réception. Cette temporisation peut être facilement réalisée à l'aide d'une ligne à retard formée d'éléments programmables.

Si après le test effectué à l'étape 24 il s'avère que le niveau du signal reçu n'est pas trop fort, un test a lieu à l'étape 27 pour comparer l'énergie EnHf du signal haute fréquence à la sortie du convertisseur analogique-numérique 12 à la valeur précédente de la valeur de référence Ref. Si à l'issue de ce test l'énergie mesurée est supérieure à Ref cette variable est remise à jour à l'étape 28. Sinon la variable Ref est lentement diminuée par multiplication de sa valeur par une constante Fr à l'étape 29. La nouvelle valeur de la variable Ref qui est obtenue est comparée à l'étape 30 à une valeur de seuil bas désigné par Seuil B, on vérifie également que le gain haute fréquence (Gain HF) n'a pas atteint sa valeur maximale. Si la valeur de la variable Ref est inférieure au Seuil B et que le gain n'est pas maximal le procédé continue par l'exécution de l'étape 31 qui consiste à augmenter d'un pas fixe de 6 dB par exemple le gain haute fréquence, à multiplier la référence Ref par deux, à multiplier par deux l'énergie basse fréquence EnBf en attendant un délai correspondant au temps de propagation du signal à travers la chaîne de réception, à multiplier l'énergie haute fréquence EnHf par deux et à multiplier l'énergie moyenne EnMoy par deux. Si la référence Ref est supérieure ou égale au seuil le gain HF n'est pas modifié. Ce gain HF n'est pas modifié si sa valeur maximale est atteinte.

Dans le procédé qui vient d'être décrit l'atténuation à appliquer dans la chaîne analogique est calculée en fonction du niveau du signal mesuré à la sortie du convertisseur analogique-numérique 12 et des constantes de temps souhaitées pour effectuer la commande automatique de gain. Le temps global de réaction du dispositif de commande automatique de gain HF peut être calculé en appliquant les règles suivantes. Si le signal reçu sur le convertisseur numérique-analogique 12 n'a pas une amplitude trop importante pour saturer celui-ci, le temps de réaction est alors pris égal au temps de réaction de la boucle de commande automatique de gain basse fréquence en dehors des temps de propagation, car le temps de réaction de la boucle de commande de gain automatique haute fréquence n'est pas à prendre en compte. Par contre, si le signal appliqué sur le convertisseur analogique-numérique 12 dépasse d'une quantité déterminée, par exemple d'au moins 12 dB le niveau maximal accepté par le convertisseur 12, il est nécessaire alors d'ajouter au temps de réaction le temps de positionnement des atténuateurs et des amplificateurs à gain variable et de propagation dans le filtre à fréquence intermédiaire 2, en plus du temps de mesure de l'énergie haute fréquence et du calcul de la commande automatique de gain haute fréquence. Enfin, si le signal dépasse de n fois la quantité déterminée 12 dB précédente il faut ajouter n fois le temps précédent. Pour réguler le niveau reçu sur le convertisseur analogique-numérique 12 les amplificateurs sont formés par des amplificateurs à gain fixe suivis d'atténuateurs à poids dont le rapport d'atténuation varie par paliers, par exemple de 6 dB. Cela permet un contrôle plus rapide et plus précis du gain global de chaîne. De cette façon, la régulation du niveau du signal appliqué sur le convertisseur analogique-numérique 12 est obtenu en déterminant combien de poids d'atténuation sont à commuter dans la chaîne de réception selon l'algorithme décrit précédemment à l'aide de la figure 2. Pour cela le niveau du signal reçu est mesuré directement en sortie du convertisseur analogique-numérique 12. En désignant par $X_i$ les échantillons de signal numérique obtenus à la sortie du convertisseur analogique-numérique 12 l'énergie du signal est calculée en appliquant la relation :

$$E = \frac{1}{N} \sum_{i=1}^{N} |X_i| \qquad (1)$$

Cette relation permet d'éviter d'employer une fonction racine carrée plus complexe à mettre en oeuvre. En choisissant judicieusement la valeur N égal à une puissance de 2 la division 1 sur N est obtenue par un simple décalage binaire. L'erreur de précision provoquée par l'utilisation de la relation (1) précédente reste inférieure à 1,5 dB par rapport à un calcul d'énergie qui serait réalisé à l'aide de la relation :

$$E = \sqrt{\frac{1}{N} \sum_{i=1}^{N} X_i^2} \qquad (2)$$

La valeur de N détermine sur combien de temps est effectuée la mesure. Une valeur trop faible donne une mesure imprécise et une mesure trop élevée a pour conséquence un ralentissement d'exécution de l'algorithme de calcul de commande automatique de gain. Mais pour le calcul de l'énergie EnHf(n) et celui de l'énergie moyenne EnMoy(n) calculée respectivement aux étapes 17 et 18 de l'algorithme de la figure 1, l'estimation de l'énergie est effectuée non pas par blocs d'échantillons mais de façon glissante suivant les relations :

$$EnHf(n) = \lambda EnHf(n-1) + (1 - \lambda)|En| \qquad (3)$$

$$EnMoy(n) = \lambda \, EnMoy(n - 1) + (1 - \lambda)En \qquad (4)$$

la valeur $\lambda$ est un facteur d'oubli compris entre 0 et 1.

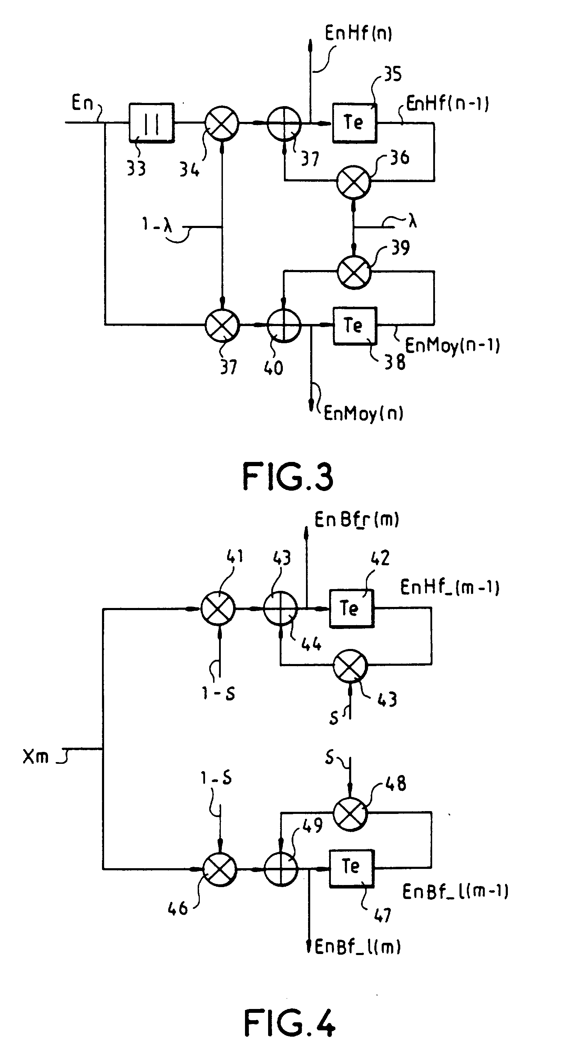

Les dispositifs de calcul des énergies EnHf(n) et En-Moy(n) sont représentés aux figures 3 et 4. Sur la figure 3 l'échantillon courant En passe au travers d'un dispositif de calcul de valeur absolue 33 pour être multiplié à l'aide d'un multiplieur 34 à une valeur constante $1-\lambda$. La valeur précédente de l'énergie EnHf(n-1) est conservée pendant la durée d'un échantillon dans un dispositif de mémorisation 35 pour être multipliée par la constante $\lambda$ grâce à un multiplieur 36. Le résultat de la multiplication est appliqué à une première entrée d'opérande d'un additionneur 37 qui reçoit sur une deuxième entrée d'opérande le produit $1-\lambda$x valeur absolue de En fournie par le multiplieur 34. Le calcul de l'énergie moyenne EnMoy(n) est réalisé de façon similaire à l'aide des dispositifs 37, 38, 39 et 40.

L'algorithme mis en oeuvre pour la commande automatique de gain basse fréquence est basé également sur un calcul d'énergie 19 du signal obtenu à la sortie du filtre numérique décimeur 13. Deux mesures d'énergie sont effectuées en parallèle en utilisant deux constantes de temps différentes $\delta$ et $\gamma$. Une mesure rapide est effectuée à l'aide de la constante $\delta$ pour traiter des variations brutales d'énergie particulièrement importantes lors de l'apparition du signal utile alors que la mesure lente est effectuée à l'aide d'une constante $\delta$ proche de 1 au moyen des relations suivantes :

$$EnBfr(m) = \delta \, EnBfr(m-1) + (1-\delta)|Xm| \qquad (5)$$

$$EnBfl(m) = \gamma \, EnBfl(m-1) + (1+\gamma)|Xm| \qquad (6)$$

Ces relations supposent que le signal en sortie du dispositif de filtrage de canal 13 est réel. Dans le cas contraire il faudrait remplacer dans les relations (3) et (4) précédentes Xm par

$$Ym = Im+jQm \qquad (7)$$

et la valeur |Xm| serait remplacée par |Im| + |Qm|.

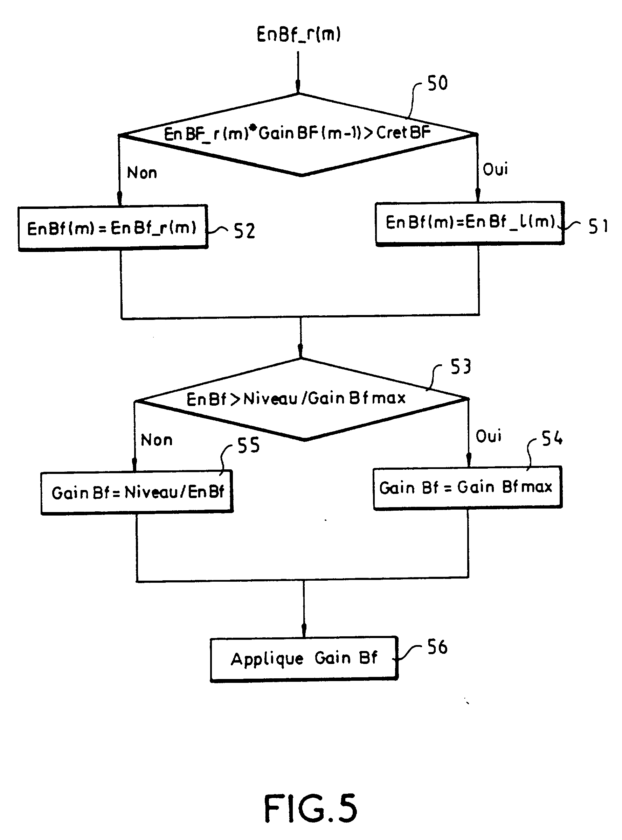

Ces calculs sont exécutés par le dispositif représenté à la figure 4. Sur cette figure le signal EnBfr(m) est obtenu par multiplication de la valeur d'échantillon Xm par la constante $1-\delta$ au travers du circuit multiplieur 41. L'énergie du signal EnHfr(n-1) calculée précédemment est mémorisée dans une mémoire 42 pour être multipliée à la constante $\delta$ par le circuit multiplieur 43. Le signal EnBfr(m) est obtenu en sortie du circuit additionneur 44 qui additionne les signaux obtenus en sortie des circuits multiplieurs 41 et 43. Le signal EnBf$\ell$(m) est obtenu de façon similaire par les circuits 46 à 49. Le gain BF est calculé de la façon représentée par les étapes 50 à 56 de l'organigramme de la figure 5. A l'étape 50 un test a lieu pour comparer le produit EnBfr(m) que multiplie le gain BF(m-1) à une valeur de seuil déterminée CretBf. En fonction du résultat, l'énergie du signal Bf(EnBf(m)) est pris égal à la mesure lente EnBfℓ(m) à l'étape 51 si le produit est supérieur à la valeur de seuil CretBf ou à la mesure rapide EnBfr(m) à l'étape 52 s'il est inférieur à cette valeur de seuil. La valeur obtenue est alors divisée par le gain maximal autorisé gain Bfmax. Le résultat obtenu désigné ci-après par "Niveau" est alors comparé à l'énergie courante EnBf pour choisir aux étapes 54 et 55 un gain maximal ou bien appliquer un gain intermédiaire égal à Niveau divisé par l'énergie EnBf. Finalement le gain BF obtenu est appliqué à l'échantillon courant Xm à l'étape 56 et 14 par application des relations

$$Xm \leftarrow Xm * \text{Gain Bf} \qquad (8)$$

ou

$$Im + jQm \leftarrow Im*\text{Gain Bf}+jQm*\text{Gain Bf} \qquad (9)$$

Naturellement, une mise en oeuvre des dispositifs de mesure d'énergie 17, 19 et des dispositifs de commande de gain 16 et 18 pourra être faite à l'aide d'un microprocesseur de traitement de signal du commerce convenablement programmé pour permettre la réalisation des étapes des figures 2 et 5 décrites précédemment pour illustrer le procédé.

Il va également de soi que l'exemple de mise en oeuvre de l'invention décrit précédemment n'est pas unique et que d'autre part, les valeurs numériques qui ont été données à titre d'exemple pour clarifier l'exposé, peuvent revêtir selon les applications des valeurs différentes.

Notamment, la mise en oeuvre de la partie analogique de la chaîne de traitement n'est qu'un exemple et peut être modifiée sans remettre en cause le dispositif. En particulier la position des composants 3, 7 et 11 de contrôle de gain et leur nature (atténuateur variable ou fixe, amplificateur variable ou fixe) peut revêtir des configurations différentes.

## Revendications

1. Procédé de commande automatique du gain d'un récepteur radio numérique comportant une chaîne d'amplification à fréquence intermédiaire (2 ... 11) couplée à un convertisseur analogique-numérique (12) consistant à mesurer (17, 19) l'énergie haute fréquence du signal appliqué par la chaîne d'amplification à fréquence intermédiaire sur le convertisseur analogique-numérique (12), à mesurer après filtrage canal l'énergie basse fréquence du signal de sortie du récepteur caractérisé en ce qu'il consiste à commander le gain de la chaîne d'amplification à fréquence intermédiaire à partir des énergies haute fréquence et basse fréquence du signal en comparant l'énergie haute fréquence courante à une valeur de seuil d'énergie Ref déterminée en fonction de l'énergie haute fréquence du signal appliqué sur le convertisseur analogique-numérique (12).

2. Procédé selon la revendication 1 caractérisé en ce que la mesure de l'énergie basse fréquence du signal est mesurée après filtrage numérique (13) des échantillons de signal fourni par le convertisseur analogique-numérique (12).

3. Procédé selon l'une quelconque des revendications 1 et 2 caractérisé en ce qu'il consiste à actualiser la valeur de référence d'énergie Ref en fonction de l'énergie haute fréquence du signal appliqué sur le convertisseur analogique-numérique (12).

4. Procédé selon la revendication 3 caractérisé en ce qu'il consiste à diminuer le gain de la chaîne d'amplification lorsque l'énergie moyenne haute fréquence courante est supérieure à au moins la première valeur de seuil déterminée "Seuil H" supérieure à la valeur de référence d'énergie Ref.

5. Procédé selon la revendication 4 caractérisé en ce qu'il consiste à égaliser la valeur de référence d'énergie Ref à la valeur de l'énergie haute fréquence mesurée lorsque cette dernière est comprise entre la première valeur de seuil déterminée "Seuil H" et la valeur de référence d'énergie Ref courante.

6. Procédé selon la revendication 4 caractérisé en ce qu'il consiste à augmenter (31) le gain de la chaîne à fréquence intermédiaire lorsque l'énergie haute fréquence mesurée est inférieure à la valeur de référence d'énergie Ref.

7. Procédé selon la revendication 4 caractérisé en ce qu'il consiste à comparer (53) l'énergie basse fréquence courante mesurée à une valeur de niveau minimal pour multiplier les échantillons de signal fourni par le filtrage numérique basse fréquence (13) par une valeur de gain maximale (54) lorsque l'énergie basse fréquence mesurée est supérieure à la valeur de niveau minimale.

8. Procédé selon la revendication 7 caractérisé en ce qu'il consiste à multiplier les échantillons de signal fourni par le filtrage numérique basse fréquence (13) par une valeur de gain intermédiaire (55) lorsque l'énergie basse fréquence mesurée est inférieure ou égale à la valeur de niveau minimale.

**9.** Procédé selon l'une quelconque des revendications 7 et 8 caractérisé en ce que la valeur de niveau minimale est égale à la valeur de l'énergie basse fréquence mesurée divisée (53) par le gain basse fréquence maximum admissible.

**10.** Procédé selon l'une quelconque des revendications 4 à 9 caractérisé en ce que la vitesse de mesure de l'énergie basse fréquence est corrélée à la variation lente ou brutale de l'énergie basse fréquence.

**11.** Procédé selon l'une quelconque des revendications 9 et 10 caractérisé en ce que la valeur de l'énergie basse fréquence mesurée est diminuée (26) lorsque l'énergie haute fréquence mesurée est supérieure au premier seuil H (24).

**12.** Procédé selon la revendication 11 caractérisé en ce que la valeur de l'énergie basse fréquence mesurée est augmentée (31) lorsque l'énergie haute fréquence mesurée est inférieure au seuil de référence Ref.

**13.** Récepteur pour la mise en oeuvre du procédé selon l'une quelconque des revendications 1 à 12 caractérisé en ce qu'il comprend un premier dispositif de commande de gain automatique (16) de la chaîne de fréquence intermédiaire programmé en fonction de l'énergie du signal fourni par le convertisseur analogique-numérique (12) placé en sortie de la chaîne de fréquence intermédiaire (2 ... 11) et un deuxième dispositif de commande de gain automatique (18) du niveau des échantillons fournis par un filtre numérique (13) placé en sortie du convertisseur analogique-numérique (12) pour commander le niveau des échantillons en fonction des énergies basse fréquence et haute fréquence du signal appliqué sur le convertisseur analogique-numérique (12).

**Claims**

**1.** Method for automatically controlling the gain of a digital radio receiver, including an intermediate-frequency amplification system (2... 11) coupled to an analog/digital converter (12), consisting in measuring (17, 19) the high-frequency energy in the signal applied by the intermediate-frequency amplification system to the analog/digital converter (12) and in measuring, after channel filtering, the low-frequency energy of the output signal of the receiver, characterized in that it consists in controlling the gain of the intermediate-frequency amplification system on the basis of the high-frequency and low-frequency energies of the signal by comparing the current high-frequency energy with an energy threshold value Ref determined as a function of the high-frequency energy of the signal applied to the analog/digital converter (12).

**2.** Method according to Claim 1, characterized in that the measurement of the low-frequency energy of the signal is measured after digitally filtering (13) the samples of signal supplied by the analog/digital converter (12).

**3.** Method according to either one of Claims 1 and 2, characterized in that it consists in updating the energy reference value Ref as a function of the high-frequency energy of the signal applied to the analog/digital converter (12).

**4.** Method according to Claim 3, characterized in that it consists in reducing the gain of the amplification system when the current average high-frequency energy is greater than at least the first determined threshold value "threshold H" greater than the energy reference value Ref.

**5.** Method according to Claim 4, characterized in that it consists in equalizing the energy reference value Ref with the value of the high-frequency energy measured when the latter is between the first determined threshold value "threshold H" and the current energy reference value Ref.

**6.** Method according to Claim 4, characterized in that it consists in increasing (31) the gain of the intermediate-frequency system when the measured high-frequency energy is less than the energy reference value Ref.

**7.** Method according to Claim 4, characterized in that it consists in comparing (53) the measured current low-frequency energy with a minimum level value in order to multiply the samples of signal supplied by the low-frequency digital filtering (13) by a maximum gain value (54) when the measured low-frequency energy is greater than tile minimum level value.

**8.** Method according to Claim 7, characterized in that it consists in multiplying the samples of signal supplied by the low-frequency digital filtering (13) by an intermediate gain value (55) when the measured low-frequency energy is less than or equal to the minimum level value.

**9.** Method according to either one of Claims 7 and 8, characterized in that the minimum level value is equal to the measured low-frequency energy value divided (53) by the maximum allowed low-frequency gain.

**10.** Method according to any one of Claims 4 to 9, characterized in that the measuring speed of the low-frequency energy is correlated with the slow or abrupt variation in the low-frequency energy.

11. Method according to either one of Claims 9 and 10, characterized in that the measured low-frequency energy value is reduced (26) when the measured high-frequency energy is greater than the first threshold H (24).

12. Method according to Claim 11, characterized in that the measured low-frequency energy value is increased (31) when the measured high-frequency energy is less than the reference threshold Ref.

13. Receiver for implementing the method according to any one of Claims 1 to 12, characterized in that it comprises a first device (16) for automatically controlling the gain of the intermediate-frequency system, this device being programmed as a function of the energy of the signal supplied by the analog/digital converter (12) placed at the output of the intermediate-frequency system (2...11), and a second device (18) for automatically controlling the gain of the level of the samples supplied by a digital filter (13) placed at the output of the analog/digital converter (12) in order to control the level of the samples as a function of the low-frequency and high-frequency energy of the signal applied to the analog/digital converter (12).

**Patentansprüche**

1. Verfahren zur automatischen Verstärkungsregelung in einem digitalen Funkempfänger, der eine Zwischenfrequenzverstärkungskette (2..11) aufweist, die mit einem Analog/Dialog-Umsetzer (12) verbunden ist, bei dem die Hochfrequenzenergie des von der Zwischenfrequenzverstärkungskette an den Analog/Dialog-Umsetzer (12) angelegten Signals gemessen wird (17, 19) und nach Kanalfilterung die Niederfrequenzenergie des am Ausgang des Empfängers auftretenden Signals gemessen wird, dadurch gekennzeichnet, daß die Verstärkung der Zwischenfrequenzverstärkungskette ausgehend von der Hochfrequenz- und der Niederfrequenzenergie des Signals geregelt wird, indem die gerade vorliegende Hochfrequenzenergie mit einem Energieschwellenwert Ref verglichen wird, der in Abhängigkeit von der Hochfrequenzenergie des an den Analog/Digital-Umsetzer (12) angelegten Signals bestimmt wird.

2. Verfahren nach Anspruch 1, dadurch gekennzeichnet, daß die Messung der Niederfrequenzenergie des Signals nach der digitalen Filterung (13) der Abtastwerte des von dem Analog/Digital-Umsetzer (12) gelieferten Signals durchgeführt wird.

3. Verfahren nach einem der Ansprüche 1 und 2, dadurch gekennzeichnet, daß der Energiereferenzwert Ref in Abhängigkeit von der Hochfrequenzenergie des an den Analog/Digital-Umsetzer (12) angelegten Signals aktualisiert wird.

4. Verfahren nach Anspruch 3, dadurch gekennzeichnet, daß die Verstärkung der Verstärkungskette jedesmal dann verringert wird, wenn der gerade vorliegende Mittelwert der Hochfrequenzenergie über wenigstens dem ersten Schwellenwert mit der Bezeichnung "Schwelle H" liegt, der größer als der Energiereferenzwert Ref ist.

5. Verfahren nach Anspruch 4, dadurch gekennzeichnet, daß der Energiereferenzwert Ref jedesmal dann mit dem gemessenen Hochfrequenzenergiewert gleichgesetzt wird, wenn letzterer zwischen dem ersten Schwellenwert mit der Bezeichnung "Schwelle H" und dem gerade vorliegenden Energiereferenzwert Ref liegt.

6. Verfahren nach Anspruch 4, dadurch gekennzeichnet, daß die Verstärkung der Zwischenfrequenzkette jedesmal dann erhöht wird (31), wenn die gemessene Hochfrequenzenergie kleiner als der Energiereferenzwert Ref ist.

7. Verfahren nach Anspruch 4, dadurch gekennzeichnet, daß die gerade vorliegende gemessene Hochfrequenzenergie mit einem minimalen Pegelwert verglichen wird (53), um jedesmal dann, wenn die gemessene Hochfrequenzenergie über dem minimalen Pegelwert liegt, die Abtastwerte des von der digitalen Niederfrequenzsiebfilterung (13) gelieferten Signals mit einem maximalen Verstärkungswert (54) zu multiplizieren.

8. Verfahren nach Anspruch 7, dadurch gekennzeichnet, daß die Abtastwerte des von der digitalen Niederfrequenzsiebfilterung (13) gelieferten Signals jedesmal dann, wenn die gemessene Niederfrequenzenergie kleiner oder gleich dem minimalen Pegelwert ist, mit einem mittleren Verstärkungswert (55) multipliziert werden.

9. Verfahren nach einem der Ansprüche 7 und 8, dadurch gekennzeichnet, daß der minimale Pegelwert gleich dem gemessenen Niederfrequenzenergiewert geteilt (53) durch die maximal zulässige Niederfrequenzverstärkung ist.

10. Verfahren nach einem der Ansprüche 4 bis 9, dadurch gekennzeichnet, daß die Geschwindigkeit der Messung der Niederfrequenzenergie in Korrelation zu der langsamen oder plötzlichen Veränderung der Niederfrequenzenergie steht.

11. Verfahren nach einem der Ansprüche 9 und 10, dadurch gekennzeichnet, daß der gemessene Wert der Niederfrequenzenergie jedesmal dann verringert wird (26), wenn die gemessene Niederfrequenzenergie über der ersten Schwelle H liegt (24).

12. Verfahren nach Anspruch 11, dadurch gekennzeichnet, daß der gemessene Wert der Niederfrequenzenergie jedesmal dann vergrößert wird (31), wenn die gemessene Niederfrequenzenergie kleiner als die Referenzschwelle Ref ist.

13. Empfänger zur Durchführung des Verfahrens nach einem der Ansprüche 1 bis 12, dadurch gekennzeichnet, daß er eine erste Vorrichtung (16) zur automatischen Regelung der Verstärkung der Zwischenfrequenzkette umfaßt, die in Abhängigkeit von der Energie des von dem am Ausgang der Zwischenfrequenzkette (2..11) angeordneten Analog/Digital-Umsetzer (12) gelieferten Signals programmiert ist, und eine zweite Vorrichtung (18) zur automatischen Verstärkungsregelung des Pegels der von dem am Ausgang des Analog/Digital-Umsetzers (12) angeordneten digitalen Filter (13) gelieferten Abtastwerte umfaßt, um den Pegel der Abtastwerte in Abhängigkeit von der Nieder- und Hochfrequenzenergie des Signals zu regeln, das an dem Analog/Digital-Umsetzer (12) anliegt.

FIG.1

EnMoy

EnMoy > Ecret — 20 — Oui

Non

EnHf > Seuil H — 24 — Oui

Non

EnHf > Ref — Oui

27

Non

Ref = Ref * Fr — 29

Ref = EnHf — 28

Ref < SeuilB et Gain HF ≠ max — 30 — Non

Oui

Gain HF = Gain HF + 6dB

Ref = Ref * 2

En Bf = EnBF * 2 après tempo

En Hf = En Hf * 2

En Moy = En Moy * 2

31

Gain Hf ≠ min — 25 — Non

Oui

Gain HF = Gain HF - 6dB

Ref = Ref / 2

En Bf = En Bf / 2 après tempo

En Hf = En Hf / 2

En Moy = En HMoy / 2

26

Gain Hf = Gain Hf - 12dB — 21

Gain Hf < min — 22 — Non

Oui

Gain Hf = min — 23

Applique Nouveau Gain HF

32

## FIG.2

FIG.3

FIG.4

EnBf_r(m)

```
                    EnBf_r(m)
                        │
                        ▼
              ╱───────────────────╲          ╭─ 50
             ╱  En BF_r(m)*Gain BF(m-1) > Cret BF ╲
    Non  ◄──╱                               ╲──► Oui
        │    ╲───────────────────╱              │
        ▼                                        ▼
┌────────────────────┐              ┌────────────────────┐
│ EnBf(m) = EnBf_r(m) │─ 52          │ EnBf(m)=EnBf_L(m) │─ 51
└────────────────────┘              └────────────────────┘
        │                                        │
        └────────────────┬───────────────────────┘
                         ▼
                ╱───────────────────╲        ╭─ 53
               ╱  EnBf > Niveau/Gain Bf max ╲
      Non ◄───╱                             ╲──► Oui
         │     ╲───────────────────╱            │
      ╭─ 55                                   ╭─ 54
         ▼                                       ▼
┌────────────────────┐              ┌────────────────────┐
│ Gain Bf = Niveau/EnBf │            │ Gain Bf = Gain Bf max │
└────────────────────┘              └────────────────────┘
        │                                        │
        └────────────────┬───────────────────────┘
                         ▼
              ┌────────────────────┐
              │  Applique  Gain Bf  │─ 56
              └────────────────────┘
```

# FIG.5